# DEMANDE DE BREVET EUROPEEN

(11) **EP 2 613 618 A1**
(43) Date de publication de la demande: **10.07.2013**
(21) Numéro de dépôt: 13150625.5
(22) Date de dépôt: 09.01.2013
(51) Int. Cl.: H05K 5/06

(54) **Boitier pour dispositif électronique**

(30) Priorité: 09.01.2012 FR 1250222
(71) Demandeur: Hikob, 69603 Villeurbanne Cedex (FR)
(72) Inventeur: Chelius, Guillaume, 69603 Villerbanne cedex (FR); Roche, Guillaume, 69603 Villeurbanne Cedex (FR); Braillon, Christophe, 69603 Villuerbanne cedex (FR); Fraboulet, Antoine, 69603 Villeurbanne cedex (FR)
(74) Mandataire: Le Cacheux, Samuel L.R.

(57) **Abrégé**

L'invention concerne un boitier pour dispositif électronique comprenant :
- un corps creux (1) qui forme au moins un logement (3) de réception d'un dispositif électronique (E) et qui comprend une ouverture (4) d'accès au logement (3) entourée par un bord périphérique (10), extérieur au logement (3), de forme tronconique ou tronc-pyramidale convergeant vers l'ouverture (4),
- un couvercle (2) de fermeture du logement (3) qui comprend un rebord périphérique (11) dont la paroi périphérique (12) intérieure possède une forme tronconique ou tronc-pyramidale complémentaire de la forme du bord périphérique (10) de l'ouverture (4),
le rebord (11) du couvercle (2) étant adapté pour s'emmancher sur le bord périphérique (10) de l'ouverture (4) et y être maintenu par adhérence.

## Description

La présente invention concerne le domaine technique des boîtiers de protection de dispositifs électroniques. Dans une application préférée mais non exclusive, l'invention se rapporte au domaine des boîtiers étanches pour des dispositifs électroniques autonomes.

Dans le domaine ci-dessus, il est connu de mettre en oeuvre des boîtiers de protection en matière plastique comprenant un corps creux cylindrique de révolution sur lequel est vissé un bouchon associé à une garniture d'étanchéité qui se trouve interposée entre le bouchon le corps cylindrique et pressée par ce dernier. De tels boîtiers donnent pleinement satisfaction en ce qui concerne leur fonction de protection d'un dispositif électronique à l'intérieur du corps creux mais présentent l'inconvénient d'induire un temps d'assemblage relativement important en raison du vissage du bouchon. De plus, la présence des filets à la fois sur le bouchon et le corps creux impose la mise en oeuvre de moules relativement complexes et onéreux.

Il est donc apparu le besoin d'un nouveau type de boîtier qui possède des caractéristiques de protection équivalentes voire supérieures à celle des boîtiers selon l'art antérieur tout en présentant un coût de fabrication moindre et en induisant un temps de montage très inférieur à celui des boîtiers selon l'art antérieur.

Afin d'atteindre ces objectifs l'invention concerne un boitier pour dispositif électronique comprenant :
- un corps creux qui forme au moins un logement de réception d'un dispositif électronique et qui comprend une ouverture d'accès au logement entourée par un bord périphérique, extérieur au logement, de forme tronconique ou tronc-pyramidale convergeant vers l'ouverture,
- un couvercle de fermeture du logement qui comprend un rebord périphérique dont la paroi périphérique intérieure possède une forme tronconique ou tronc-pyramidale complémentaire de la forme du bord périphérique de l'ouverture,
le rebord du couvercle étant adapté pour s'emmancher sur le bord périphérique de l'ouverture et y être maintenu par adhérence.

La fixation du couvercle sur le corps creux par emmanchement conique permet de réaliser rapidement la fermeture du corps creux par son couvercle. De plus, l'emmanchement conique permet, si besoin est, de réaliser directement l'étanchéité de la fermeture sans qu'il soit nécessaire de prévoir des garnitures d'étanchéité complémentaire. Ainsi, dans le cas de pièces réalisées en matière plastique avec des moules présentant un état de surface normale ou ordinaire et dépourvues de fenêtre il est possible d'obtenir une étanchéité de classe IP55. Par ailleurs, les surfaces tronconiques ou tronc-pyramidales du couvercle et du corps creux peuvent être obtenu avec des moules de forme simple peut onéreux. Il est à noter que les formes tronconiques ou tronc pyramidales se démoulent naturellement de par leur conception. De plus, dans la mesure où il est quasiment impossible de démonter l'assemblage sans détruire en partie le couvercle ou le corps, le boîtier selon l'invention constitue un système à témoin d'ouverture permettant d'apporter la preuve de l'intégrité du contenu du boîtier.

Selon l'invention la forme du bord périphérique et de la paroi périphérique est tronconique au sens général du terme c'est-à-dire qu'elle correspond à une surface définie par l'intersection de deux plans avec une figure géométrique à trois dimensions engendrée par des droites génératrices passant par un sommet et s'appuyant sur une courbe fermée dite directrice. Selon l'invention, la directrice est susceptible de présenter différentes formes telles que par exemple un polygone, un cercle ou une ellipse sans que cette liste ne soit ni limitative, ni exhaustive.

De manière préférée, l'emmanchement mis en oeuvre par l'invention est de type cône morse, cône métrique à 5 % ou encore cône Brown & Sharpe.

Ainsi, selon une caractéristique de l'invention, la pente du bord périphérique et de la paroi périphérique est comprise entre 1° et 3°.

De même, selon une autre caractéristique de l'invention la pente du bord périphérique et de la paroi périphérique est comprise entre 1 % et 5,5%.

Selon une forme de réalisation de l'invention, le couvercle et le corps comprennent des moyens d'orientation du couvercle par rapport au corps. La mise en oeuvre de tels moyens d'orientation permettent de coordonner la position d'inscriptions ou d'un repère portés par le couvercle et du dispositif électronique disposé dans le corps. Cette possibilité permet d'utiliser les inscriptions du couvercle pour orienter convenablement le boitier et le dispositif électronique qu'il contient en fonction de l'environnement de mise en oeuvre.

Selon une variante de cette forme de réalisation, les moyens d'orientation comprennent au moins une nervure qui s'étend en saillie du bord périphérique du corps et qui est destinée à s'engager dans une rainure complémentaire aménagée dans le rebord.

Selon une autre variante de cette forme de réalisation, le couvercle comprend sur une face extérieure un repère d'orientation.

Selon l'invention le logement du corps creux peut être réalisé de toute manière appropriée. Selon une caractéristique de l'invention, le logement comprend :
- à l'opposé de l'ouverture, une chambre de réception au moins une batterie ou pile,
- et entre l'ouverture et la chambre de réception, une chambre d'accueil d'un dispositif électronique.

Selon une caractéristique de l'invention, le bord et la paroi périphériques possèdent une forme tronconique de révolution.

Selon une autre caractéristique de l'invention, le corps et le couvercle possèdent une forme générale symétrique de révolution.

Selon l'invention le boitier peut comprendre des fenêtres permettant par exemple une circulation d'air entre l'intérieur du boitier et le milieu extérieur.

Selon une forme de réalisation de l'invention, le boitier est dépourvu de fenêtre de manière à être étanche une fois que le couvercle est emmanché sur le corps.

Selon une variante de cette forme de réalisation, le corps et/ou le couvercle comprend au moins une garniture d'étanchéité périphérique destinée à participer à l'étanchéité de la fermeture du corps par le couvercle.

Bien entendu, les différentes caractéristiques, variantes et formes de réalisation de l'invention peuvent être associées les unes avec les autres selon diverses combinaisons dans la mesure où elles ne sont pas incompatibles ou exclusives les unes des autres.

Par ailleurs, diverses autres caractéristiques de l'invention ressortent de la description annexée effectuée en référence aux dessins qui illustrent des formes non limitatives de réalisation de boitiers conformes à l'invention.
- La figure 1 est une perspective extérieure schématique d'un boitier selon l'invention.
- La figure 2 est perspective éclatée du boitier illustré à la figure 1 montrant le dispositif électronique qu'il renferme.
- La figure 3 est une perspective extérieure schématique du corps creux constitutif du boitier illustré à la figure 1.
- La figure 4 est une coupe axiale du corps creux illustré à la figure 3.
- La figure 5 est une perspective extérieure schématique du couvercle constitutif du boitier illustré à la figure 1.
- La figure 6 est une coupe axiale du couvercle illustré à la figure 5.
- La figure 7 est une coupe axiale de l'assemblage du corps creux illustré à la figure 3 avec le couvercle illustré à la figure 5.
- La figure 8 est une coupe axiale d'une variante de réalisation d'un boitier selon l'invention.
- Les figures 9 et 10 sont des perspectives extérieures schématiques d'une autre forme de réalisation d'un boitier selon l'invention.
- La figure 11 est une perspective schématique arrachée du boitier illustré aux figures 9 et 10.
- La figure 12 illustre en perspective schématique encore une autre forme de réalisation d'un boitier selon l'invention.
Il est à noter que sur ces figures les éléments structurels et/ou fonctionnels communs aux différentes variantes peuvent présenter les mêmes références.

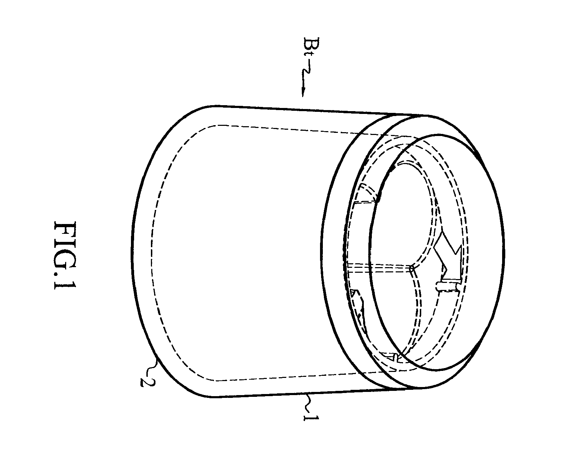

Un boitier Bt selon l'invention, tel qu'illustré à la figure 1, comprend un corps creux 1, représenté en traits discontinus, fermé par un couvercle 2 montré en traits pleins.

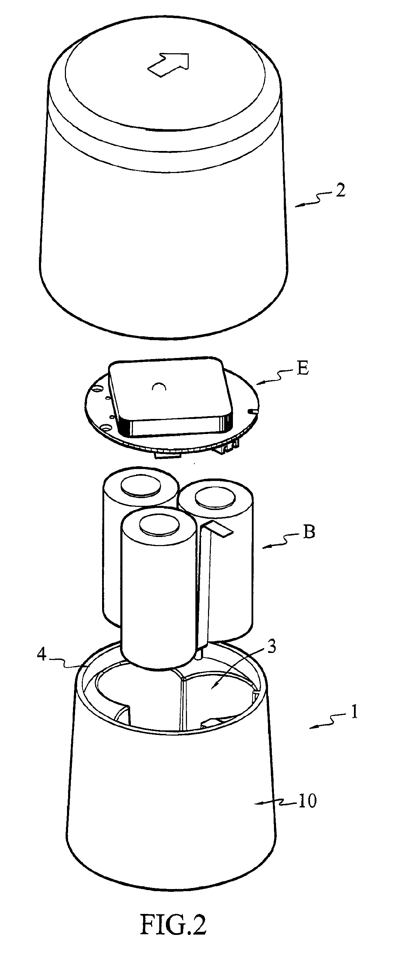

Comme cela ressort de la figure 2, le corps creux 1 définit un logement 3 de réception d'un dispositif électronique E et de ses batteries d'alimentation B. Selon l'exemple illustré, le logement 3 est accessible à partir d'une ouverture 4. Le logement 3 comprend à l'opposé de l'ouverture 4 une chambre de réception 3₁ de trois batteries B et, entre l'ouverture 4 et la chambre de réception 3₁, une chambre d'accueil 3₂ du dispositif électronique E.

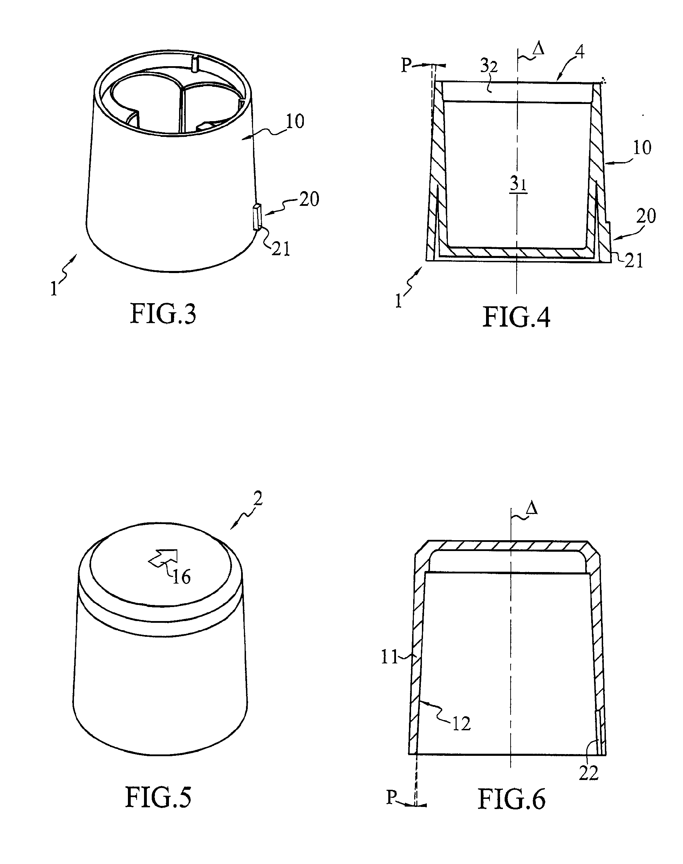

L'ouverture 4 est entourée, à l'extérieur de logement 3, par un bord périphérique 10 qui présente une forme tronconique convergeant vers l'ouverture 4 comme le montrent les figures 3 et 4. Selon l'exemple illustré, le bord périphérique 10 possède une forme tronconique de révolution d'axe Δ et s'étend sur toute la hauteur du corps creux 1.

Afin de permettre son emmanchement sur le corps creux 1, le couvercle 2 comprend un rebord périphérique 11 dont la paroi périphérique intérieure 12 possède, comme cela ressort des figures 5 et 6, une forme tronconique complémentaire de la forme tronconique du bord périphérique 10.

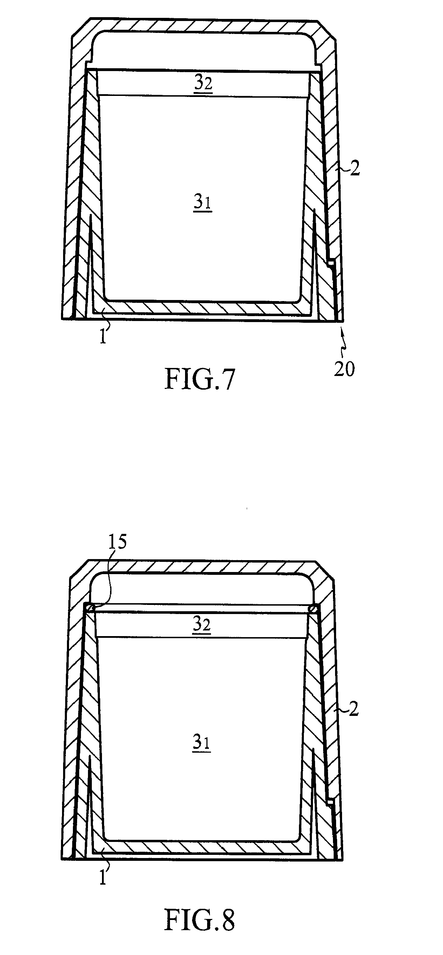

L'assemblage du boîtier selon l'invention s'effectue de la manière suivante. Les batteries B et le dispositif électronique E sont successivement placés dans le logement 3. Ensuite, le couvercle 2 est engagé sur le corps creux 1 de manière que le rebord périphérique 11 vient s'emmancher sur le bord périphérique 10 comme le montre la figure 7. Les formes tronconiques complémentaires de la paroi périphérique intérieure 12 et du bord périphérique 10 induisent une fixation par adhérence du couvercle 2 sur le corps creux 1 sans qu'il soit nécessaire de recourir à un autre mode de fixation complémentaire tel qu'un collage ou une liaison mécanique. Il apparaît donc que l'assemblage du boîtier selon l'invention s'effectue de manière simple et rapide sans outillage particulier de sorte que cet assemblage peut être réalisé juste avant la mise en oeuvre du dispositif électronique E.

Afin de garantir l'efficacité de cette fixation par adhérence, les formes tronconiques de la paroi périphérique intérieure 12 et du bord périphérique 10 sont de préférence choisies pour réaliser un cône morse, un cône métrique à 5 % ou encore un cône Brown & Sharpe. Ainsi, la pente P du bord périphérique 10 et de la paroi périphérique intérieure 12 est par exemple comprise entre 1° et 3° ou encore comprise entre 1% et 5,5%.

Selon l'exemple illustré, le corps creux 1 ne comprend pas d'autre ouverture que l'ouverture 34 d'accès au logement 3 tandis que le couvercle 2 ne comprend pas d'autre ouverture que celle permettant l'engagement du rebord périphérique 11 sur le bord périphérique 10. Ainsi, une fois assemblé, le boîtier, formé du couvercle 2 emmanché sur le corps creux 1 est donc dépourvu de fenêtre et hermétiquement fermé et se trouve étanche à l'eau. Lorsque que le corps creux 1 et le couvercle 2 sont réalisés en matière plastique injectée dans des moules présentant un état de surface ordinaire, le boîtier Bt résultant de leur assemblage présente une étanchéité de classe IP55 au moins sans qu'il soit nécessaire de recourir à des accessoires d'étanchéité complémentaire. Dans ce cadre la mise en oeuvre d'une huile de silicone ou encore, comme cela est illustré à la figure 8, d'une garniture d'étanchéité 15 périphérique permet d'atteindre une classe d'étanchéité IP65. Une telle classe d'étanchéité peut également être atteinte en mettant en oeuvre des moules présentant un état de surface miroir pour les parties formant la paroi intérieure périphérique 12 et le bord périphérique 10 de sorte que le simple contact entre ces derniers permet d'obtenir l'étanchéité recherchée.

Selon l'exemple illustré et décrit précédemment, le couvercle 2 présente une forme de cloche est englobe complètement le corps creux 1 de sorte qu'il est quasiment impossible de les séparer sans les endommager. Ainsi, l'emmanchement conique mis en oeuvre par l'invention, permet d'assurer l'intégrité du dispositif électronique E enfermé dans le boîtier.

Lorsque le dispositif électronique E met en oeuvre un capteur sensible à sa position dans l'environnement comme par exemple cela est le cas pour un capteur magnétique sensible au champ magnétique terrestre, le couvercle 2 présente, sur une face extérieure, un repère d'orientation 16. Afin que la position du repère 16 corresponde à l'orientation du corps creux 1 dans le couvercle 2, ces derniers comprennent des moyens 20 d'orientation du couvercle 2 par rapport au corps creux. Selon l'exemple illustré, les moyens d'orientation 20 comprennent une nervure 21 qui s'entend en saillie du bord périphérique 10 et qui est destinée à venir s'engager dans une rainure 22 aménagée dans la paroi périphérique intérieure 12.

Selon la forme de réalisation de l'invention décrite précédemment, le boiter ainsi que le corps creux 1 et le couvercle 2 présentent une forme sensiblement tronconique de révolution avec des bases inférieure et supérieure sensiblement plane. Cependant une telle configuration n'est pas nécessaire à la réalisation d'un boitier selon l'invention.

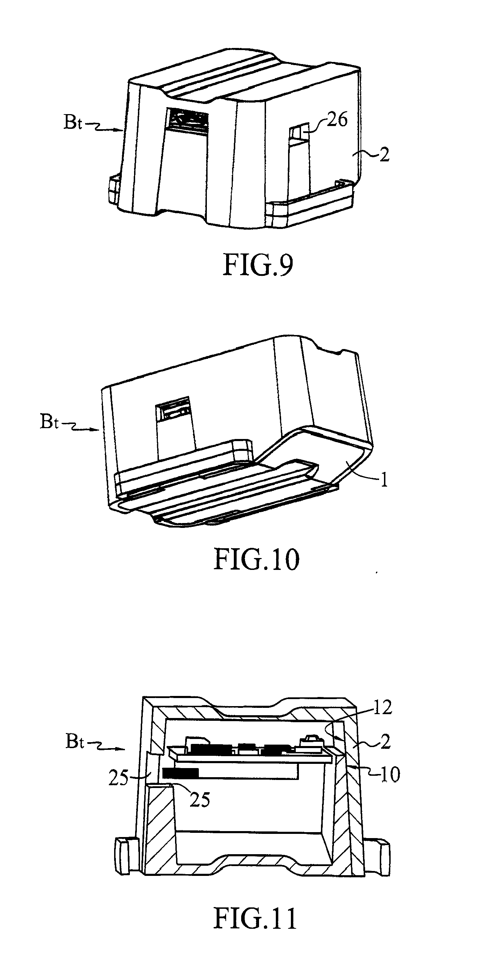

Ainsi les figures 9 à 11 illustrent un boitier Bt selon l'invention présentant une forme générale tronc-pyramidale avec des bords arrondis et des bases non planes. Selon cette forme de réalisation le bord périphérique 10 et la paroi périphérique intérieure 12 possède également une forme sensiblement tronc pyramidale. De plus, le couvercle 2 et le corps creux comprennent des ouvertures 25 de sorte que le boitier B comprend des fenêtres 26 permettant une circulation d'air entre le logement 3 et le milieu extérieur.

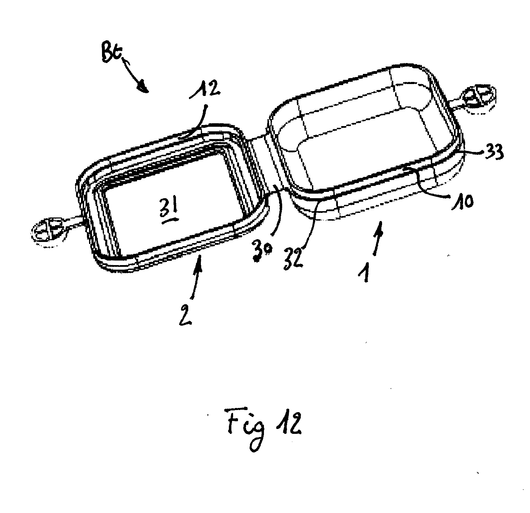

La figure 12 illustre un boitier Bt selon l'invention dont le corps creux 1 et le couvercle 2 sont liés par une charnière 30 qui en facilite la manipulation. Le bord périphérique 10 du corps creux 1 présente une forme tronc-pyramidale mâle avec des bords arrondis tandis que la paroi périphérique intérieure 12 du couvercle possède une forme sensiblement tronc pyramidale femelle complémentaire. De plus, le couvercle 2 comprend une ouverture 31 permettant la mise en place d'un panneau solaire d'alimentation d'un dispositif électronique disposé dans le boitier BT. Afin de parfaire l'étanchéité du boîtier Bt assurée au niveau de l'emmanchement tronconique du bord périphérique 10 dans la paroi périphérique intérieure 12, le bord périphérique 10 du corps creux 1 est bordé par un rebord 32 portant un joint d'étanchéité 33 qui se trouve pincé entre le rebord 32 et le bord 34 du couvercle 2 lorsque le boitier BT est fermé.

Bien entendu, diverses autres modifications peuvent être apportées au boitier selon l'invention dans le cadre des revendications annexées.

## Revendications

1. Boitier pour dispositif électronique comprenant :
- un corps creux (1) qui forme au moins un logement (3) de réception d'un dispositif électronique (E) et qui comprend une ouverture (4) d'accès au logement (3) entourée par un bord périphérique (10), extérieur au logement (3), de forme tronconique ou tronc-pyramidale convergeant vers l'ouverture (4),
- un couvercle (2) de fermeture du logement (3) qui comprend un rebord périphérique (11) dont la paroi périphérique (12) intérieure possède une forme tronconique ou tronc-pyramidale complémentaire de la forme du bord périphérique (10) de l'ouverture (4),
le rebord (11) du couvercle (2) étant adapté pour s'emmancher sur le bord périphérique (10) de l'ouverture (4) et y être maintenu par adhérence.

2. Boitier selon la revendication précédente, caractérisé en que la pente du bord périphérique (10) et de la paroi périphérique (12) est comprise entre 1° et 3°.

3. Boitier selon l'une des revendications précédentes, **caractérisé en ce que** en que la pente du bord périphérique (10) et de la paroi périphérique (12) est comprise entre 1% et 5,5%

4. Boitier selon l'une des revendications précédentes, **caractérisé en ce que** le corps (1) et/ou le couvercle (2) comprend une garniture d'étanchéité périphérique (15) destinée à participer à l'étanchéité de la fermeture du corps (1) par le couvercle (2).

5. Boitier selon l'une des revendications précédentes, **caractérisé en ce que** le couvercle (2) et le corps (1) comprennent des moyens (20) d'orientation du couvercle (2) par rapport au corps (1).

6. Boitier selon la revendication 5, **caractérisé en ce que** les moyens d'orientation comprennent au moins une nervure (21) qui s'étend en saillie du bord périphérique (10) du corps (1) et qui est destinée à s'engager dans une rainure (22) complémentaire aménagée dans le rebord (11).

7. Boitier selon la revendication 5 ou 6, **caractérisé en ce que** le couvercle (2) comprend sur une face extérieure un repère d'orientation (16).

8. Boitier selon l'une des revendications précédentes, **caractérisé en ce que** le logement (3) comprend :
- à l'opposé de l'ouverture (4), une chambre de réception (3₁) d'au moins une batterie ou pile,
- et, entre l'ouverture (4) et la chambre de réception (3₁), une chambre d'accueil (3₂) d'un dispositif électronique (E).

9. Boitier selon d'une des revendications précédentes, **caractérisé en ce qu'il** est étanche lorsque le couvercle (2) est emmanché sur le corps (1).

10. Boitier selon l'une des revendications précédentes, caractérisé en que le corps (1) et le couvercle (2) possèdent une forme générale symétrique de révolution.
